(19) Europäisches Patentamt
European Patent Office
Office européen des brevets

(11) Veröffentlichungsnummer: **0 286 594**
**A2**

(12) # EUROPÄISCHE PATENTANMELDUNG

(21) Anmeldenummer: **88810207.6**

(51) Int. Cl.⁴: **G 03 F 7/16**

(22) Anmeldetag: **28.03.88**

(30) Priorität: **06.04.87 CH 1314/87**
**15.06.87 CH 2245/87**

(43) Veröffentlichungstag der Anmeldung:
**12.10.88 Patentblatt 88/41**

(84) Benannte Vertragsstaaten:
**CH DE FR GB IT LI NL SE**

(71) Anmelder: **CIBA-GEIGY AG**
**Klybeckstrasse 141**
**CH-4002 Basel (CH)**

(72) Erfinder: **Jehle, Nikolaus**
**Haldenweg 25**
**CH-4133 Pratteln (CH)**

**Losert, Ewald**
**Habsburgerstrasse 30**
**CH-4310 Rheinfelden (CH)**

**Meier, Kurt, Dr.**
**Im Kirschgarten 35**
**CH-4102 Binningen (CH)**

(54) **Verfahren zur Herstellung von photostrukturierbaren Ueberzügen.**

(57) Verfahren zur Herstellung von photostrukturierbaren Ueberzügen, worin

(i) ein zu beschichtendes Material, gegebenenfalls nach Erwärmung, mit einem Pulverlack enthaltend
(A) eine strahlungshärtbare Verbindung und gegebenenfalls
(B) einen strahlunsaktivierbaren Polymerisatinsinitiator für (A)
elektrostatisch beschichtet wird,

(ii) das beschichtete Material erwärmt wird, um ein Schmelzen des Pulvers zu einem Film, der nach Abkühlung fest ist, zu bewirken,

(iii) der feste Film in einem vorbestimmten Muster aktinischer Strahlung ausgesetzt wird, bei der die strahlungshärtbare Verbindung (A) und/oder der strahlungsaktivierbare Polymerisationsinitiator (B) aktiviert werden, so dass in den bestrahlten Bereichen die Komponente (A) ganz oder teilweise gehärtet wird, gegebenenfalls

(iv) das beschichtete Material erhitzt wird, und dadurch die belichteten Teile einer thermischen Nachbehandlung unterzogen werden,

(v) die Bereiche des Films, die nicht gehärtet sind, durch Entwicklung entfernt werden und gegebenenfalls

(vi) das beschichtete Material wieder erhitzt wird und dabei (A) nachgehärtet wird.

Das Verfahren ermöglicht die Herstellung von photostrukturierbaren Ueberzügen, wie z.B. Galvanoresists oder vorzugsweise Lötstoppmasken ohne Verwendung von Lösungsmitteln bei der Beschichtung, wie bei Flüssigresists, und ohne Gebrauch von Hilfsfolien, die bei Trockenresists benötigt werden.

EP 0 286 594 A2

**Beschreibung**

## Verfahren zur Herstellung von photostrukturierbaren Ueberzügen

Die Erfindung betrifft ein Verfahren zur Herstellung von photostrukturierbaren Ueberzügen durch Beschichtung eines Basismaterials mit einem photoempfindlichen Pulverlack, Bestrahlung der Beschichtung in einem vorbestimmten Muster durch aktinische Strahlung und anschliessende Entwicklung der nicht bestrahlten Bereiche.

Photostrukturierbare Ueberzüge finden unter anderem als Galvanoresists oder als Lötstoppmasken Anwendung.

Galvano-Resists dienen zur Abdeckung der Teile einer Leiterplatte, die bei einer weiteren galvanischen Oberflächenbehandlung in den entsprechenden Techniken keine Metallabscheidung annehmen dürfen. Da die galvanische Oberflächenbehandlung im Fertigungsprozess gedruckter Schaltungen ein teurer Arbeitsvorgang ist, werden an Galvano-Resists sehr hohe Anforderungen gestellt. Die wichtigsten Kriterien sind daher:

- gute Beständigkeit gegenüber sauren und alkalischen Elektrolyten während teilweise sehr langer Expositionszeiten
- sehr feine Konturenzeichnung bei gleichzeitig relativ dickem Lackauftrag
- gute Haftfestigkeit als Voraussetzung für das Arbeiten mit hohen Stromdichten und hohen Stromausbeuten
- hohe Porendichte des Lackfilms; Porosität kann leicht zu Durchschlägen bzw. Metallablagerungen führen ("Griessbildung")
- insgesamt gute dielektrische Eigenschaften
- gute Relation von Fliess-Viskosität und Struktur-Viskosität, damit beim Druck gute Konturenschärfe und gleichzeitig ein gutes Stehvermögen des Lackes an den Druckrändern, insbesondere bei höheren Leiterzügen, erzielt werden.

Bei der Herstellung von gedruckten Schaltungen ist es üblich, die Leiterzüge zum Schutz vor äusseren Einflüssen mit einer dünnen Isolations- und Schutzschicht zu versehen. Diese Schichten dienen oft gleichzeitig als Lötstoppmasken, um bei späteren Lötverfahren einen unerwünschten Kontakt der Leiterzüge zu verhindern.

Als Beschichtungsverfahren hat sich zum Aufbringen der dünnen Schichten, insbesondere das Vorhanggiessverfahren bewährt. Dieses ist zum Beispiel in der US 4,230,793 beschrieben. Ein anderes übliches Verfahren zur Herstellung von photostrukturierbaren Ueberzügen ist die Verwendung von UV vernetzbaren Folienresists (Trockenresist).

An die photopolymerisierbaren Lacke werden hohe Anforderungen gestellt. Sie müssen eine hohe Bildauflösung und Entwickelbarkeit, eine gute Haftung auf dem Leitermetall und auf Kunstharzen sowie eine hohe thermische, mechanische, elektrische und chemische Resistenz haben. Zur Erzielung solcher Eigenschaften muss eine Schutzschicht erreicht werden, die frei von Poren und Blasen ist. Um den Anforderungen beim Lötvorgang zu genügen, muss zudem die mit einem Lötstopplack hergestellte Schutzmaske Temperaturen von z.B. 270°C während 10 Sekunden schadlos überstehen.

Photostrukturierbare Ueberzüge, wie z.B. Galvanoresists oder Lötstoppmasken werden üblicherweise unter Verwendung lösungsmittelhaltiger photoempfindlicher Lacke hergestellt. Solche Lacke und ihre Anwendung zur Herstellung eines Lötmusters sind zum Beispiel in der GB-A 2 032 939 beschrieben. Bei der Herstellung solcher Ueberzüge wird die Leiterplatte mit einer Lösung einer photopolymerisierbaren Substanz in einem flüchtigen organischen Lösungsmittel beschichtet, das Lösungsmittel wird verdampft, wodurch ein Film der photopoly merisierbaren Substanz entsteht, der Film wird durch eine Vorlage aktinisch bestrahlt, wobei die bestrahlten Teile des Films photopolymerisieren und dadurch weniger löslich werden, während die von der Strahlung geschützten Teile im wesentlichen unverändert bleiben. Anschliessend werden die nicht bestrahlten, nicht polymeriserten Teile des Films mit einem geeigneten Lösungsmittel, welches die bestrahlten photopolymerisierten Teile nicht löst, weggelöst. Diese letzte Stufe wird üblicherweise "Entwicklung" genannt.

Wünschenswert wäre ein Verfahren, bei dem eine Schicht einer photopolymerisierbaren Substanz auf die Leiterplatte appliziert wird und diese Schicht in einer festen, nicht-klebrigen Form ist, welche man durch eine Vorlage belichten kann, ohne dabei organische Lösungmittel verwenden zu müssen. Dadurch liessen sich nicht nur die mit der Verwendung von Lösungsmitteln verbundenen Proleme der Toxizität und Entflammbarkeit sowie die Kosten der Wiedergewinnung der Lösungmittel vermeiden, sondern auch die beim Verdampfen des Lösungsmittels durch Blasen- und Porenbildung in der photoempfindlichen Schicht entstehenden Probleme, würden nicht auftreten. Ausserdem wäre auch eine Beeinträchtigung der Endeigenschaften (wie z.B. Wasserbeständigkeit) durch Restlösungsmittel im gehärteten Film ausgeschlossen.

Es wurde nun gefunden, dass dieses Ziel erreicht werden kann, wenn zur Herstellung von photostrukturierbaren Ueberzügen bestimmte photoempfindliche Pulverlacke verwendet werden.

Pulverlacke auf der Basis verschiedener Bindemittel sind seit langem bekannt. Dabei werden üblicherweise elektrische Leiter, wie z.B. Metalle, mit der Pulvermischung insbesondere elektrostatisch beschichtet. Wie der Fachmann weiss, ist es aber äusserst schwierig, sowohl Leiter als auch Nichtleiter gleichmässig elektrostatisch zu beschichten.

Gegenstand der vorliegenden Erfindung ist ein Verfahren zur Herstellung von photostrukturierbaren Ueberzügen, worin

(i) ein zu beschichtendes Material, gegebenenfalls nach Erwärmung, mit einem Pulverlack enthaltend
(A) eine strahlungshärtbare Verbindung und gegebenenfalls
(B) einen strahlungsaktivierbaren Polymerisatinsinitiator für (A) elektrostatisch beschichtet wird,
(ii) das beschichtete Material erwärmt wird, um ein Schmelzen des Pulvers zu einem Film, der nach Abkühlung fest ist, zu bewirken,
(iii) der feste Film in einem vorbestimmten Muster aktinischer Strahlung ausgesetzt wird, bei der die strahlungshärtbare Verbindung (A) und/oder der strahlungsaktivierbare Polymerisationsinitiator (B) aktiviert werden, so dass in den bestrahlten Bereichen die Komponente (A) ganz oder teilweise gehärtet wird, gegebenenfalls
(iv) das beschichtete Material erhitzt wird, und dadurch die belichteten Teile einer thermischen Nachbehandlung unterzogen werden,
(v) die Bereiche des Films, die nicht gehärtet sind, durch Entwicklung entfernt werden und gegebenenfalls
(vi) das beschichtete Material wieder erhitzt wird und dabei (A) nachgehärtet wird.

Das im erfindungsgemässen Verfahren zu beschichtende Material kann z.B. ein Leiter, sowie ein mit Leitern versehener Nichtleiter, z.B. eine Leiterplatte, sein. Die hergestellten photostrukturierbaren Ueberzüge können insbesondere als Galvanoresist oder besonders bevorzugt als Lötstoppmasken verwendet werden.

Das erfindungsgemässe Verfahren ermöglicht die gleichmässige Beschichtung von Leiterplatten ohne Verwendung lösungsmittelhaltiger Lacke. Es werden poren- und blasenfreie gleichmässige Beschichtungen mit guter Haftung erzielt. Zudem ist die gleichzeitige beidseitige Beschichtung möglich, und die Schichtdicke kann vom Anwender nach Wunsch variiert werden. Das Aufbringen der Beschichtung erfolgt ohne dass auf der Platte vorhandene Bohrstellen verstopft werden, so dass Polymerreste bei der Entwicklung vollständig entfernt werden. Eine Anwendung von Hilfsfolien, wie beim Trockenresist, wie z.B. in US 4,289,841 beschrieben, ist dabei nicht nötig. Der nach dem vorliegenden Verfahren erhaltene Lötstopplack ermöglicht z.B. eine gute Einbettung der Leiterbahnen und weist eine gute thermische, mechanische, elektrische und chemische Resistenz auf.

Die DE-OS 25 18 656 beschreibt Stoffgemische enthaltend Epoxidharze und Oniumsalze von Elementen der Gruppe Va des Periodensystems. Die Stoffgemische sind strahlungshärtbar und werden bevorzugt in flüssiger Form, unter anderem auch als Photoresist angewendet. Es wird auch erwähnt, dass die Stoffgemische als frei fliessendes Pulver verwendet werden können, und in einem Beispiel wird die Beschichtung einer Stahlplatte mit einem Pulverlack und anschliessende Photohärtung der Beschichtung beschrieben. Diese Literaturstelle offenbart aber weder die Verwendung von Pulverlacken als Photoresist, und noch weniger legt sie den Einsatz von strahlungshärtbaren Pulverlacken für die Herstellung von Galvanoresists oder Lötstoppmasken für Leiterplatten nahe. Bei diesen Anwendungen müssen strukturierte Oberflächen vollständig beschichtet werden. Dabei ist es insbesondere wichtig, dass der Lack auch alle auf den Leiterplatten eventuell vorhandenen Hinterschneidungen gänzlich ausfüllt, ein wesentliches Erfordernis für einen genügenden Schutz der Leiter.

Die US 4,307,177 offenbart lösungsmittelhaltige Beschichtungen hergestellt durch Strahlungsvernetzung kationisch polymerisierbarer Substanzen ohne Epoxidgruppen in Gegenwart von strahlungsempfindlichen aromatischen Haloniumsalzen. Die Beschichtungen können unter anderem auch zur Bilderzeugung als Resist verwendet werden.

Im erfindungsgemässen Verfahren werden als Komponente (A) des Pulverlackes strahlungshärtbare Verbindungen eingesetzt. Geeignete strahlungshärtbare, lackbildende Verbindungen sind dem Fachmann geläufig. Es kommen sowohl Substanzen in Frage, welche, gegebenenfalls in Anwesenheit eines kationischen Photoinitiators, kationisch polymerisieren, als auch solche, welche, gegebenenfalls in Anwesenheit eines radikalischen Photoinitiators, über Radikale polymerisieren.

Eine bevorzugte Gruppe strahlungshärtbarer Verbindungen der ersten Art sind Epoxidharze. Als Epoxidharze können die üblichen, für Pulverbeschichtungen geeigneten Epoxidharze verwendet werden. Solche Verbindungen sind beispielsweise in der DE-OS 28 38 841 beschrieben. Die verwendeten Harze haben vorzugsweise einen Epoxidgehalt von 0,5 bis 12 Aequivalenten pro kg, sind bei Zimmertemperatur fest und können, falls erforderlich, durch Umsetzung mit z.B. einem zweiwertigen Phenol vorverlängert werden. Bevorzugt sind Epoxidharze, die im Durchschnitt mehr als eine Epoxidgruppe pro Molekül enthalten, insbesondere Polyglycidylderivate von Aromaten, Heteroaromaten oder Cycloaliphaten. Besonders bevorzugte Epoxidharze sind gegebenenfalls vorverlängerte Polyglycidylether eines Bisphenols, wie z.B. Bisphenol A, Tetrabrombisphenol A oder Bisphenol F, oder insbesondere Polyglycidylether eines Novolaks, wie z.B. eines Phenol- oder Kresolnovolaks. Es können auch Gemische verschiedener Epoxidharze verwendet werden.

Bei Verwendung von Epoxidharzen als Komponente (A) des im vorliegenden Verfahren eingesetzten Pulverlacks werden vorzugsweise erfindungsgemäss als strahlungsaktivierbare Polymerisationsinitiatoren (B) kationische Photoinitiatoren eingesetzt. Eine weitere Verbindungsklasse, die mit kationischen Photoinitiatoren härtbar ist, stellen die Vinylether dar. Bevorzugte kationische Photoinitiatoren sind Haloniumsalze, Iodosylsalze, Sulfoniumsalze, Sulfoxoniumsalze oder insbesondere Metallocensalze. Beispiele solcher Halonium-, Iodosyl- und Sulfoniumsalze sind z.B. die unter den Formeln II, IV und III in der EP-A 153 904 erwähnten Verbindungen. Geeignete Sulfoxoniumsalze sind beispielsweise in den EP-A 35 969, EP-A 44 274, EP-A 54 509 und EP-A 164 314 beschrieben.

Eine Uebersicht über weitere gängige Oniumsalzinitiatoren bietet "UV-Curing, Science and Technology"

(S.P.Pappas, Technology Marketing Corp., Stanford, Connecticut, USA).

Bevorzugte Photoinitiatoren sind Metallocensalze, wie beispielsweise in der EP-A 94 915 beschrieben, insbesondere Eisen-Aren-Komplexe, wie z.B. Verbindungen der Formel I

$$\left[ R^1(Fe^{II}R^2)_s \right]_t^{+s} \left[ X \right]_s^{-t} \qquad (I),$$

worin s 1 oder 2 bedeutet, t 1, 2, 3, 4 oder 5 ist, X für ein nicht nukleophiles Anion steht, $R^1$ ein $\pi$-Aren ist und $R^2$ ein Anion eines $\pi$-Arens, bevorzugt Cyclopentadienyl, bedeutet.

Beispiele für bevorzugte $\pi$-Arene $R^1$ sind Cumol, Naphthalin, Methylnaphthalin oder Stilben.

Beispiele für Anionen X sind $BF_4^-$, $PF_6^-$, $AsF_6^-$, $SbF_6^-$, $SbF_5OH^-$, $CF_3SO_3^-$, $CF_3$-$CF_2$-$SO_3^-$, $C_4F_9SO_3^-$, $TiF_6^{2-}$, Phosphorwolframat ($PO_{40}W_{12}^{3-}$) oder Siliciumwolframat ($SiO_{40}W_{12}^{4-}$).

Man kann auch Kombinationen dieser Metallocensalze mit Oxidationsmitteln einsetzen. Solche Kombinationen sind in der EP-A 126 712 beschrieben.

Zur Erhöhung der Lichtausbeute setzt man, je nach Initiatortyp, falls erwünscht, Sensibilisatoren zu.

Beispiele dafür sind polycyclische aromatische Kohlenwasserstoffe oder aromatische Ketoverbindungen. Spezifische Beispiele bevorzugter Sensibilisatoren sind in der EP-A 153 904 erwähnt.

Weitere Verbindungsklassen, die erfindungsgemäss als kationische Photoinitiatoren (B) eingesetzt werden können, sind Mischungen aus einem Aluminium-Chelat, wie z.B. Aluminium-Acetylacetonat oder -salicylat, mit Silanen, wie beispielsweise

$$^{t}Bu-O-O-SiPh_3 \quad \text{oder} \quad ^{t}Bu-O-O-\underset{Ph}{\overset{Ph}{Si}}-O-O-^{t}Bu\ .$$

Solche Verbindungen sind z.B. in den EP-A 103 305, EP-A 91 131, EP-A 76 102 und EP 135 887 beschrieben.

Eine weitere Gruppe bevorzugter, im erfindungsgemässen Verfahren einsetzbarer strahlungshärtbarer Verbindungen (A) sind ethylenisch ungesättigte Verbindungen. Dabei sind Ester ethylenisch ungesättigter Monocarbonsäuren, Vinylgruppen enthaltende Verbindungen oder Maleinimideinheiten enthaltende Verbindungen bevorzugt. Bevorzugte strahlungshärtbare ethylenisch ungesättigte Verbindungen (A) enthalten mindestens eine, vorzugsweise mindestens 2, Gruppen der Formel II

$$CH_2=\overset{R}{C}-COO- \qquad (II),$$

worin R Wasserstoff, Chlor oder Brom oder eine $C_1$-$C_4$-Alkylgruppe ist. Es kann sich dabei zum Beispiel um Polyether-Acrylate, Polyester-Acrylate, Polyester-Urethan-Acrylate, Urethanacrylate oder insbesondere Epoxidacrylate handeln. Geeignete Verbindungen der erwähnten Art sind dem Fachmann bekannt und können auf bekannte Weise hergestellt werden. Sie sind z.B. in den US 3,380,831, US 3,297,745, US 4,129,488 und US 3,586,526 bis '530 beschrieben. Es können auch Polycaprolactone, wie z.B. die in US 3,700,643 offenbarten, Zimtsäurederivate oder Alkyd-Urethan-Acrylate, wie z.B. in US 3,673,140 beschrieben, eingesetzt werden.

Als Maleinimidyleinheiten enthaltende strahlungshärtbare Verbindungen (A) sind z.B. die in US 4,115,368, US 4,079,041 und US 4,544,621 beschriebenen Polymere zu erwähnen.

Verschiedene Typen UV-härtbarer Polymere sind beispielsweise in "Ultraviolet Radiation Cured Coatings", Journal of Paint Technology, Bd. 46, No. 596, S. 60 (1974) sowie in American Paint Journal, vom 4.9.1972 auf S. 26 beschrieben.

Besonders strahlungshärtbare ethylenisch ungesättigte Verbindungen (A) sind, wie erwähnt Epoxid-Acrylate. Solche Verbindungen sind z.B. in den US 4,129,488, US 3,586,526 bis '530 und DE-OS 29 44 097 beschrieben. Sie können zum Beispiel durch Umsetzung von Epoxidharzen mit geeigneten (Meth)Acrylsäurederivaten hergestellt werden. Die üblichen Epoxid-Acrylate enthalten praktisch keine nicht reagierten Epoxidgruppen mehr. Es können aber auch doppelfunktionelle Verbindungen, bei denen nur ein Teil der Epoxidgruppen umgesetzt wurde und welche daher sowohl Epoxid- als auch (Meth)Acrylatgruppen enthalten, verwendet werden.

Erfindungsgemäss können auch Gemische verschiedener definitionsgemässer Verbindungen als Komponenten (A) bzw. (B) des Pulverlacks eingesetzt werden.

Beim erfindungsgemässen Einsatz von strahlungshärtbaren ethylenisch ungesättigten Verbindungen (A) werden geeigneterweise als strahlungsaktivierbare Polymerisationsinitiatoren (B) radikalische Photoinitiatoren eingesetzt. Bevorzugte radikalische Photoinitiatoren sind Benzoine, Benzophenone, Acetophenone, Thioxanthone oder Metallocene, insbesondere Titanocene.

Folgende Verbindungsklassen sind z.B. als Komponente (B) geeignet:

1) Aroylketale der Formel III

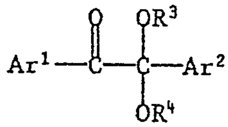 (III),

worin

$Ar^1$ Phenyl oder durch $C_1$-$C_4$-Alkyl oder Halogen substituiertes Phenyl ist,

$Ar^2$ eine der für $Ar^1$ gegebenen Bedeutungen hat oder Wasserstoff, $C_1$-$C_8$-Alkyl oder $C_5$-$C_8$-Cycloalkyl bedeutet,

$R^3$ und $R^4$ unabhängig voneinander $C_1$-$C_6$-Alkyl, $C_3$-$C_4$-Alkenyl, $C_7$-$C_{10}$-Phenylalkyl oder durch Halogen, $C_1$-$C_4$-Alkoxy, $C_2$-$C_8$-Dialkylamino, Morpholino oder Piperidino substituiertes $C_2$-$C_4$-Alkyl bedeuten, oder $R^3$ und $R^4$ zusammen $C_2$-$C_{12}$-Alkandiyl oder 2-Buten-1,4-diyl bedeuten.

Solche Verbindungen sind aus den US-PS 3,715,293, 3,998,712, 4,485,249 und der GB-PS 1 390 006 bekannt.

2) Benzoin-Derivate der Formel IV

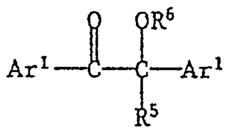 IV,

worin

$Ar^1$ Phenyl oder durch $C_1$-$C_4$-Alkyl oder Halogen substituiertes Phenyl bedeutet,

$R^5$ Wasserstoff, $C_1$-$C_4$-Alkyl, Allyl, Benzyl, Hydroxymethyl oder ($C_1$-$C_4$-Alkoxy)methyl bedeutet,

$R^6$ Wasserstoff, $C_1$-$C_6$-Alkyl, $C_3$-$C_8$-Alkoxyalkyl, Allyl oder Benzyl bedeutet oder $R^5$ und $R^6$ zusammen $-CH_2-O-CH_2-$, $-CH_2-O-C(CH_3)_2-$oder $-CH_2-O-CH(C_6H_5)-$ bedeuten.

Solche Verbindungen sind z.B. in den DE-PS 1 694 149 und 1 923 266 beschrieben.

3) Acetophenonderivate der Formel V

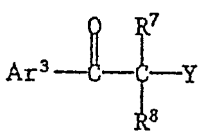 (V),

worin

$Ar^3$ Phenyl oder durch einen oder mehrere der Reste Halogen, $C_1$-$C_{18}$-Alkyl, $C_3$-$C_{12}$-Alkenyl, $C_1$-$C_{12}$-Alkoxy, $C_1$-$C_{12}$-Alkylthio, $C_1$-$C_{12}$-Alkylamino, $C_2$-$C_{24}$-Dialkylamino, $C_4$-$C_8$-Bis(hydroxyalkyl)-amino, Phenoxy, Phenylthio, 4-Tolylthio, 2-Hydroxyethylthio, Allyloxy, Allylthio, Diallylamino, Bis(2-methoxyethyl)amino, Morpholino, Piperidino oder Pyrrolidino substituiertes Phenyl bedeutet,

$R^7$ und $R^8$ unabhängig voneinander $C_1$-$C_8$-Alkyl oder durch OH, $C_1$-$C_4$-Alkoxy, Benzyloxy, -CN, -COO($C_1$-$C_8$-Alkyl), $C_2$-$C_8$-Dialkylamino oder Morpholino substituiertes $C_1$-$C_4$-Alkyl bedeuten, oder $R^7$ und $R^8$ zusammen $C_2$-$C_9$-Alkandiyl, ($C_1$-$C_4$-Alkoxy)-pentandiyl-1,5, $C_3$-$C_9$-Oxa- oder Azaalkandiyl oder $C_5$-$C_9$-Alkendiyl bedeuten und

Y eine Gruppe $-OR^9$ oder $-NR^{10}R^{11}$ bedeutet, worin $R^9$ Wasserstoff, $C_1$-$C_8$-Alkyl, durch OH, $C_1$-$C_4$-Alkoxy oder CN substituiertes $C_2$-$C_4$-Alkyl, Allyl, Benzyl oder Trimethylsilyl bedeutet oder $R^9$ und $R^7$ zusammen eine Gruppe $-CH_2-O-CH_2-$, $-C(CH_3)_2-O-CH_2-$, $-CH(CH_3)-O-CH_2-$ oder $-CH(C_6H_5)-O-CH_2-$ bedeuten und $R^{10}$ und $R^{11}$ unabhängig voneinander Wasserstoff, $C_1$-$C_{12}$-Alkyl, durch OH, $C_1$-$C_4$-Alkoxy, -CN oder -COO($C_1$-$C_4$-Alkyl) substituiertes $C_2$-$C_4$-Alkyl, Allyl, Benzyl oder Cyclohexyl bedeuten oder $R^{10}$ und $R^{11}$ zusammen $C_3$-$C_7$-Alkandiyl bedeuten, das durch -O- oder $-NR^{12}$-unterbrochen sein kann, wobei $R^{12}$ Wasserstoff, $C_1$-$C_4$-Alkyl oder $C_2$-$C_4$-Hydroxyalkyl bedeutet. Solche Verbindungen sind z.B. in der DE-OS 2 722 264 und der EP-A-3002 beschrieben.

4) Ester von Arylglyoxylsäuren der Formel VI

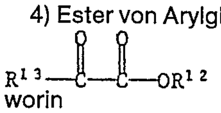 (VI),

worin

$R^{12}$ ein unverzweigter oder verzweigter aliphatischer $C_1$-$C_{10}$-Kohlenwasserstoffrest, Phenyl, Benzyl, Cyclohexyl oder Trimethylsilyl ist und

$R^{13}$ unsubstituiertes $C_6$-$C_{14}$-Aryl oder durch eine oder mehrere der Gruppen Alkyl, Alkoxy, Aryloxy, Alkylthio, Arylthio oder Halogen substituiertes Phenyl bedeutet.

$R^{12}$ als aliphatischer Rest kann z.B. Methyl, Ethyl, Propyl, Butyl, Pentyl, Hexyl, 2-Ethylbutyl, Octyl, 2-Ethylhexyl, Nonyl, Decyl, Allyl oder Methallyl sein. $R^{13}$ kann z.B. Phenyl, Diphenylyl, Naphthyl, Anthracyl, Tolyl, Xylyl, Methoxyphenyl, Phenoxyphenyl oder Chlorphenyl sein. Solche Verbindungen sind z.B. in den US-PS 4,038,164 und 4,519,883 beschrieben.

5) Acylphosphinoxide der Formel VII

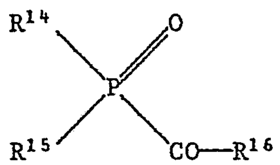

(VII),

worin

$R^{14}$ $C_1$-$C_6$-Alkyl, $C_5$-$C_6$-Cycloalkyl, unsubstituiertes oder durch Halogen, Alkyl oder Alkoxy substituiertes $C_6$-$C_{10}$-Aryl oder ein S oder N enthaltender 5- oder 6-gliedriger heterocyclischer Rest ist,

$R^{15}$ eine der für $R^{14}$ gegebenen Bedeutungen hat oder $C_1$-$C_6$-Alkoxy, $C_6$-$C_{10}$-Aryloxy oder $C_7$-$C_{10}$-Aralkyloxy ist, oder $R^{14}$ und $R^{15}$ zusammen mit dem P-Atom einen Ring bilden und

$R^{16}$ ein $C_2$-$C_{18}$-Alkylrest, ein $C_2$-$C_4$-Alkenylrest, ein $C_5$-$C_{12}$ cycloaliphatischer Rest, ein durch Alkyl, Alkoxy oder Alkylthio substituierter Phenyl- oder Naphthylrest oder ein S oder N enthaltender 5- oder 6-gliedriger heterocyclischer Rest ist oder eine Gruppe -Z-CO-P(O)($R^{14}$)($R^{15}$) ist, worin Z Phenylen oder $C_2$-$C_6$-Alkylen bedeutet.

Bevorzugt ist $R^{16}$ ein tertiärer $C_4$-$C_{12}$-Alkylrest oder ein aromatischer oder heterocyclischer Rest, der in beiden Orthostellungen zur Bindung an die Carbonylgruppe durch je eine Gruppe Alkyl, Alkoxy oder Alkylthio substituiert ist.

Die Verbindungen der Formel VII sind tertiäre Acylphosphinoxide oder Acylphosphinsäure-ester. Sie sind z.B. in den US-PS 4,265,723 und 4,292,152 beschrieben.

Geeignete Metallocen-Photoinitiatoren sind z.B. in EP-A 94 914, EP-A 94 915, EP-A 126 712, EP-A 152 377, EP-A 207 889 und EP-A 122 223 beschrieben. Geeignete Titanocene sind insbesondere in der EP-A 186 626 offenbart.

Die erfindungsgemäss einsetzbaren Pulverlacke können ferner noch Weichmacher, wie Dibutylphthalat, Dioctylphthalat oder Trikresylphosphat, oder sonstige Additive enthalten, wie Streckmittel, Füllstoffe und Färbemittel. Geeignete Streckmittel und Füllstoffe sind beispielsweise Glimmer, Tonerde, Gips, Talk, Titandioxid, Kreide, Quarzmehl, Cellulose, Kaolin, gemahlener Dolomit, Wollastonit, Kieselerde mit grosser spezifischer Oberfläche (erhältlich unter dem Handelsnamen "Aerosil"), mit langkettigen Aminen modifizierte Tonerde (erhältlich unter dem Handelsnamen "Bentone"), gepulvertes Polyvinylchlorid, Polyolefine oder Aminoplaste sowie Metallpulver, wie Kupfer-, Silber-, Aluminium- oder Eisenpulver. Flammschutzmittel, wie Antimontrioxid, können ebenfalls den härtbaren Mischungen zugegeben werden.

Den Pulverlacken können noch weitere in der Lackindustrie übliche Zusätze, wie beispielsweise Lichtschutzmittel, und insbesondere Entgasungsmittel, Verlaufsmittel thermische Härter, Füllstoffe und/oder Pigmente beigegeben werden.

Verlaufsmittel sind z.B. Polyvinylactale, wie Polyvinylbutyral ("Mowital" B 30 H® der HOECHST), Polyethylenglykol, Polyvinylpyrrolidon, Glycerin, Neopentylglykol, Acryl-Mischpolymerisate, wie "Modaflow"® oder "Acrylron" MFP® der MONSANTO bzw. der PROTEX, sowie "Acronal" 4F® der Firma BASF und "Uresin B® der Firma HOECHST (ein Carbamidsäureharz aus Butylurethan und Formaldehyd).

Als Entgasungsmittel wird vorzugsweise Benzoin eingesetzt.

Als Füllstoff wird insbesondere Talk bevorzugt.

Die Pulverlacke können durch einfaches Mischen der Bestandteile, z.B. in einer Kugelmühle, hergestellt werden. Eine andere Möglichkeit der Herstellung besteht darin, dass man die Bestandteile zusammen schmilzt, vorzugsweise in einem Extruder, wie z.B. in einem Buss-Kokneter, und dann die abgekühlte Masse zerkleinert. Die Mischungen weisen vorzugsweise eine Partikelgrösse im Bereich von 0,015 bis 500 µm, und insbesondere von 1 - 75 µm, auf.

Die neben den Komponenten (A) und (B) in Pulverlack enthaltenen Zusatzstoffe werden in der Regel in kleinen Mengen, bevorzugt bis 20 Gew. %, bezogen auf die Gesamtmischung, zugesetzt. Sie müssen mit den übrigen Bestandteilen der Mischung verträglich sein.

Ferner können den Mischungen noch Katalysatoren, Beschleuniger und Härter beigegeben werden, insbesondere, wenn die Komponente (A) ein Epoxidharz ist. Diese Zusätze bewirken bei einer eventuellen thermischen Nachbehandlung eine Nachhärtung der Epoxidkomponente; gegebenenfalls erfolgt dieser Nachhärtungsschritt nach der Entwicklung des Photoresists. Geeignete Härter, welche im erfindungsgemässen Verfahren als Härter für Epoxidharze verwendet werden können, sind beispielsweise phenolische Hydroxylgruppen, Carboxylgruppen und insbesondere Carbonsäureanhydridgruppen enthaltende Verbindungen.

Die erfindungsgemäss zu verwendenden Pulverlacke enthalten bevorzugt 50 - 99,5 Gew. % der Komponente (A), 0,5 - 20 Gew.% des Photoinitaotrs (B) und 0 - 20 Gew. % der Zusatzstoffe. Dabei ergänzen

sich die Anteile der einzelnen Komponenten jeweils zu 100 % und die Mengenangaben sind auf die Gesamtmenge bezogen.

Ganz besonders bevorzugt enthalten die Pulverlacke, bezogen auf die Gesamtmenge, 60 - 99 Gew.% der Komponente (A), 1 - 10 Gew % des Photoinitiators (B) und 0 - 15 Gew. der Zusatzstoffe.

Vorzugsweise hat der erfindungsgemäss zu verwendende Pulverlack einen Erweichungspunkt im Bereich von etwa 50 bis 150° C, insbesondere etwa 65 bis 110° C.

Die Schichtdicke des Pulverlackes kann nach Bedarf variiert werden. Bevorzugt werden Schichtdicken von ca. 20 bis 200 μm, insbesondere von 30 bis 100 μm.

Der Pulverlack wird erfindungsgemäss auf das, gegebenenfalls vorgeheizte, zu beschichtende Material, z.B. auf eine Leiterplatte, mittels einer der für die Beschichtung von Gegenständen mit Pulverlacken bekannten Methoden appliziert. Geeignete Beschichtungsverfahren sind beispielsweise das Wirbelsinterverfahren oder das in der DE-OS 24 11 629 beschriebene Verfahren (elektrostatisches Wirbelsintern). Das Aufbringen des Pulverlackes kann auch mit einer elektrostatischen Pulverspritzpistole bei Spannungen von vorzugsweise 30 - 100, insbesondere 40 - 80 kV erfolgen. Dabei wird das zu beschichtende Material vorzugsweise auf eine Temperatur von über 100° C, insbesondere etwa 150 bis 200° C, vorgeheizt. Nach erfolgter Beschichtung wird das Material noch etwa 1 bis 5 Minuten bis zum Schmelzen des Pulvers zu einem porenfreien Film erwärmt. Der Film ist nach Abkühlung fest und klebfrei und kann z.B. zur Herstellung einer Lötstoppmaske belichtet werden.

Die Lichtempfindlichkeit der erfindungsgemäss verwendeten Pulverlacke reicht in der Regel von UV-Gebiet (ca. 200 nm) bis ca. 600 nm und umspannt somit einen sehr breiten Bereich. Bevorzugte Anwendung findet aktinische Strahlung einer Wellenlänge im Bereich von etwa 300 bis 550 nm. Als Lichtquellen kommt daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen.

Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlicht quellen, z.B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig; der gesteuerte Laser-Strahl schreibt direkt auf die Schicht. Hier ist die hohe Empfindlichkeit der erfindungsgemässen Materialien sehr vorteilhaft, die hohe Schreibgeschwindigkeiten bei relativ niedrigen Intensitäten erlaubt.

Nach der bildmässigen Belichtung des Materials und vor der Entwicklung kann es vorteilhaft sein, für kürzere Zeit eine thermische Behandlung durchzuführen. Dabei werden nur die bereits belichteten Teile thermisch gehärtet. Diese thermische Behandlung ist besonders empfehlenswert bei den Metallocen-Photoinitiatoren. Sie kann in konventionellen Oefen, beispielsweise in Konvektionsöfen, stattfinden, aber auch mit IR-Strahlung, beispielsweise durch Bestrahlung mit IR-Lasern, oder in Mikrowellengeräten erfolgen. Die angewandten Temperaturen liegen im allgemeinen bei 50 - 150° C, bevorzugt bei 80 - 130° C; die Härtungszeit liegt in der Regel zwischen 5 und 40 Minuten.

Nach der Belichtung und gegebenenfalls thermischen Nachbehandlung werden die unbelichteten Stellen des Photolackes in an sich bekannter Weise mit einem Entwickler entfernt.

Die Entwicklung erfolgt mit einer basischen wässrigen Lösung oder vorzugsweise mit organischen Lösungmitteln. In Frage kommen beispielsweise 2-Ethoxyethanol, Aceton, Methyl, Ethyl-Keton, γ-Butyrolacton, Benzylalkohol, n-Butyldiglykol (Diethylenglykolmonobutylether), Propylencarbonat und insbesondere Cyclohexanon sowie Mischungen dieser Lösungsmittel.

Nach der Belichtung und Entwicklung kann das Reliefbild nochmals einer thermischen Behandlung unterworfen werden. Diese erfolgt vorzugsweise bei 80 - 160° C, insbesondere bei 110 - 150° C während 10 bis 120 Minuten. Dabei reagieren verbleibende, noch nicht umgesetzte reaktive Gruppen.

Durch diese zusätzliche thermische Netzwerkbildung werden besonders resistente und dauerhafte Reliefbilder erhalten, die sich durch gute thermomechanische, chemische und elektrische Eigenschaften, insbesondere Stabilität, Haftung und hohen spezifischen Durchgangswiderstand auszeichnen.

Der Begriff 'Belichtung mit einem vorbestimmten Muster aktinischer Strahlung' beinhaltet sowohl die Belichtung durch eine Photomaske, die ein vorbestimmtes Muster enthält, beispielsweise ein Diapositiv, sowie die Belichtung durch einen Laserstrahl, der beispielsweise computergesteuert über die Oberfläche des beschichteten Substrates bewegt wird und auf diese Weise ein Bild erzeugt.

In den folgenden Beispielen wird die Erfindung näher erläutert.

Der in den Beispielen erwähnte <u>Löttest</u> wird wie folgt durchgeführt: Auf die ausgehärtete Prüfplatte wird eine Flussmittellösung aus 26 g Rein-Kolophonium und 100 ml Isopropanol mit einem Pinsel dünn aufgetragen und mindestens 20 min bei Raumtemperatur getrocknet. Die derart vorbehandelte Prüfplatte wird mit der zu prüfenden Lackschicht nach unten gerichtet auf ein bei 270 ± 5° C gehaltenes Lötbad (bestehend aus 50 % Blei und 50 % Zinn) gelegt. Nach 10 s wird die Prüfplatte vom Lötbad entfernt und leicht abgeschüttelt. Nach etwa 1 h Abkühlung wird das Flussmittel durch zweimaliges Waschen mit Isopropanol entfernt, und die Prüfplatte wird nach dem Trocknen (Abblasen mit Pressluft) mit Hilfe einer Stereolupe beurteilt. Um dem Löttest zu genügen, darf der Lack weder abheben oder abplatzen, noch Risse, Blasen oder Poren zeigen oder Zinnrückstände, wie Perlen oder Zinnschleier, aufweisen.

Die in den Ausführungsbeispielen verwendeten Photoinitiatoren entsprechen folgenden Verbindungen.
Photoinitiator I: ($\eta^6$-1-Methylnaphthalin) ($\eta^5$-cyclopentadienyl)-eisen(II)-hexafluorphosphat
Photoinitiator II: ($\eta^6$-Stilben) ($\eta^5$-cyclopentadienyl)eisen(II)-hexafluorphosphat
Photoinitiator III: ($\eta^6$-Cumol) ($\eta^5$-cyclopentadienyl)eisen(II)-hexafluorantimonat
Photoinitiator IV: Benzildimethylketal

Beispiel 1:

Eine Mischung aus
1850 g eines technischen Kresol-Novolak Epoxidharzes mit einem Epoxidgehalt von 4,25 Aequ./kg und einem Erweichungspunkt von 99°C
100 g eines Verlaufsmittelkonzentrates bestehend aus 90 % Bisphenol-A-Harz und 10 % Acrylron MFP (ein Acryl-Mischpolymerisat der Fa. PROTEX), mit einem Epoxidgehalt von 1,25 Aequ./kg
50 g Photoinitiator I
240 g Talk und
20 g Grünpigment (Heliogengrün der BASF)
wird in einem Kneter PR 46 (Firma Buss AG) aufgeschmolzen. Nach dem Abkühlen der Schmelze wird die Masse zu einem feinen Pulver vermahlen. Der so erhaltene Pulverlack weist einen Erweichungspunkt (Koflerbank) von 75 - 95°C auf. Der Pulverlack wird mit einer elektrostatischen Pulverspritzpistole (Type 705 Ransburg-GEMA AG) bei einer Spannung von 80 kV auf eine mit Kupferleiterbahnen versehene Epoxidglasfaserplatte gespritzt. Die Platte wird vor dem Spritzen auf ca. 175°C aufgewärmt und in der Sprühkabine so aufgehängt, dass einige grössere Kupferleiterbahnen mit der Erdung der Sprühpistole elektrisch verbunden sind. Es entsteht sowohl auf den Leiterbahnen als auch auf der Isolierplatte eine zusammhängende Pulverschicht, die nach einem Aufschmelzprozess von 90 s bei 175°C zu einem porenfreien Film von ca. 50 µm Filmdicke schmilzt. Die Leiterbahnen sind in die Pulverlackschicht eingebettet und die durchkontaktierten Bohrungen von ca. 0,6 mm Durchmesser sind frei von Pulverlack.

Diese Platte wird durch eine Maske mit einer Metallhalogenid-Lampe von 5000 W im Abstand von 75 cm während 120 s belichtet. Danach wird die Platte 15 Min auf 110°C erwärmt, nach dem Abkühlen mit Cyclohexanon entwickelt und anschliessend während 1 Stunde bei 135°C nachgehärtet.

Die so behandelte Leiterplatte zeigt keine sichtbare Veränderung nach dem Löttest.

Beispiel 2

Es wird ein Pulverlack analog zu Beispiel I hergestellt, wobei jedoch die Verbindung II anstelle von I als Photoinitiator eingesetzt wird.

Dieser Pulverlack wird mit einer Elektrostatik-Pulverspritzpistole mit 40 kV auf eine auf 160°C vorgewärmte Leiterplatte gespritzt. Nach dem Aufschmelzen während 90 s bei 160°C erhält man eine gleichmässige Schicht sowohl auf den Leiterbahnen als auch auf dem Isoliermaterial. Diese Leiterplatte wird wie in Bsp. 1 beschrieben während 60 s belichtet, vorgehärtet, entwickelt, nachgehärtet und dem Löttest ausgesetzt. Es wird keine sichtbare Veränderung der Resistschicht beobachtet.

Beispiel 3:

Eine Mischung aus
935 g eines technischen, bromierten Epoxidphenolnovolaks mit einem Epoxidgehalt von 3,7 Aequ./kg mit einem Bromgehalt von 36 Gew. %
50 g des im Beispiel 1 verwendeten Verlaufsmittelkonzentrates
10 g Photoinitiator III
240 g Talk
10 g Grünpigment (Irgalithgrün GLN, CIBA-GEIGY)
wird im Kneter bei einer Manteltemperatur von 80°C aufgeschmolzen. Nach dem Mahlen (Korngrösse ca. 10-100µm) wird der Pulverlack (Schmelzbereich 107 - 110°C) mit der elektrostatischen Pulverspritzpistole (80 kV) auf eine 180°C vorgewärmte Leiterplatte gespritzt. Nach dem Aufschmelzen des Pulverlacks (90 s 180°C) wird ein zusammenhängender Film von ca. 80 µm mit guter Einbettung der Leiterbahnen erhalten.

Diese Leiterplatte wird wie in Bsp. 1 beschrieben während 60 s belichtet, vorgehärtet, entwickelt, nachgehärtet und dem Löttest ausgesetzt. Es wird keine sichtbare Veränderung der Resistschicht beobachtet.

Beispiel 4: 900 g eines Epoxidacrylates, welches durch Veresterung von 86,3 Teilen eines technischen Bisphenol-A-Epoxidharzes mit einem Epoxidgehalt von 2,0 Aequ./kg und einem Erweichungsbereich von 65 - 75°C (Epikote 1001, Shell) mit 13,7 Teilen Acrylsäure nach dem in der GB-A 2 032 939 beschriebenen Verfahren hergestellt wurde,
50 g des im Beispiel 1 beschriebenen Verlaufsmittelkonzentrates
50 g Photoinitiator IV
240 g Talk.
10 g Heliogengrün (BASF)
werden im Kneter bei einer Manteltemperatur von 60°C aufgeschmolzen. Nach dem Erstarren wird die Masse

gemahlen und damit ein Pulverlack mit einem Erweichungsbereich von 67 - 84° C erhalten, der mit einer elektrostatischen Spritzpistole mit 80 kV Spannung auf eine 150° C vorgewärmte Leiterplatte gespritzt wird. Nach Aufschmelzen (2 Min/120° C) wird ein porenfreier Film mit guter Einbettung der Leiterbahnen erhalten.

Diese Leiterplatte wird wie in Bsp. 1 beschrieben während 60 s belichtet, mit Cyclohexanon entwickelt und 30 Min bei 135° C ausgehärtet. Die Platte zeigt nach dem Löttest keine sichtbare Veränderung.

Beispiel 5:

Eine Mischung aus
1850 g eines technischen Bisphenol-A-Epoxidharzes mit einem Epoxidgehalt von 1,3 Aequ./kg und einem Erweichungsbereich von 65-75° C
100 g des im Beispiel 1 verwendeten Verlaufsmittelkonzentrates
50 g Photoinitiator II
480 g Talk und
20 g Grünpigment (Heliogengrün der BASF)
wird in einem Kneter PR 46 (BUSS AG) aufgeschmolzen. Nach dem Erstarren der Schmelze wird die Masse fein vermahlen und Grobanteile mit Korngrössen >; 100 μm werden ausgesiebt. Der Pulverlack weist einen Erweichungsbereich (Koflerbank) von 76 - 97° C auf. Der Pulverlack wird mit einer elektrostatischen Pulverspritzpistole (Typ 705 der RANSBURG-GEMA AG) bei einer Spannung von 80 kV auf eine doppelseitig mit einer Kupferfolie kaschierte Epoxidglasfaserplatte von 1,6 mm Dicke gespritzt. Diese Platte weist Bohrungen von 0,6 - 1 mm Durchmesser auf und wird vor der Beschichtung mit dem Pulverlack in einem chemischen Kupferbad zwecks Durchkontaktierung behandelt. Die mit dem Pulverlack beschichtete Platte wird während 90 s auf 175° C erwärmt. Es resultiert eine homogene Beschichtung von ca. 65 μm Dicke. Die Löcher sind im wesentlichen frei von Pulverlack, und durch eine galvanische Abscheidung von Kupfer kann das chemisch abgeschiedene Kupfer in den Lochwandungen auf die erforderliche Dicke verstärkt werden. Die Platte wird durch eine Maske belichtete, nachgehärtet und in Diethylenglykolmono-n-Butylether entwickelt. Es entsteht ein Bild mit einer guten Auflösung und steilen Flanken. Die Platte wird nach folgendem Arbeitsschema in einem galvanischen Kupferbad behandelt:
- Reinigen durch 1-minütiges Tauchen in eine Lösung von BUZ-R bei 25° C (Dr.Ing. Max Schlötter GmbH + Co.AG.),
- 1 Min mit Leitungswasser spülen,
- Anätzen in einer Lösung von 120 g ENPLATE AD485 (IMASA AG, Dällikon, Schweiz) und 20 ml konzentrierter Schwefelsäure pro Liter Wasser,
- Saures Kupferbad AC der Firma Erne AG, Dällikon, 75 Min bei ca. 25° C und einer Stromdichte von 3 A/dm², 
-Spülen mit Leitungswasser.

Nach der galvanischen Behandlung der Platte weist der Galvanoresist keine Beschädigungen wie Blasen, Risse etc. auf und ist durch Strippen mit Methylenchlorid sauber entfernbar. Der erhaltene Kupferüberzug hat eine Dicke von ca. 50 μm.

Beispiel 6:

Eine Mischung aus
60 Gwt. (=Gewichtsteile) eines Epoxidacrylates, welches durch Umsetzung eines Epoxidharzes vom Bis-Phenol A-Typ mit einem Epoxidgehalt von 1,1 Aeq/kg und einem Erweichungsbereich von 75-85° C mit Acrylsäure hergestellt wurde und als technisches Produkt mit der Bezeichnung RIPOXY VR 60 von Showa Highpolymers in Japan erhältlich ist,
32,5 Gwt. des Urethanacrylates der Formel

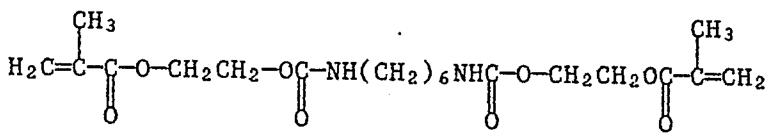 ,

hergestellt durch Umsetzung von Hexamethylendiisocyanat mit Hydroxyethylmethacrylat nach dem Verfahren von J. Kaiser et al., Israel J. Chem. 10, 157 (1972),
5 Gwt. eines Verlaufmittelkonzentrates bestehend aus 90 Gwt. des Epoxidacrylates RIPOXY VR 60 und 10 Gwt. ACRYLON MFP 250 (Acrylmischpolymerisat der Fa. PROTEX),
2,5 Gwt. Photoinitiator IV
0,5 Gwt. AEROSIL R972 (DEGUSSA)
wird während 8 Stunden in der Kugelmühle gemischt und fein vermahlen und dann durch ein Sieb von 100 μm Maschenweite gesiebt. Dieser Pulverlack wird mit einer elektrostatischen Spritzpistole auf ein Kupfer-Laminat beschichtet. Die mit dem Pulverlack beschichtete Platte wird während 4 Minuten auf 120° C erwärmt. Es entsteht ein gleichmässiger Film von ca. 50 μm Filmdicke.

Die Platte wird wie in Beispiel 1 beschrieben durch eine Maske 30 Sekunden lang belichtet und anschliessend 10 Minuten auf 110° C erwärmt. Bei der nachfolgenden Entwicklung in einem Gemisch von 50

Gwt. Propylencarbonat, 30 Gwt. Diethylenglykolmonobutylether und 20 Gwt. γ-Butyrolacton wird ein Bild mit einer guten Auflösung erhalten.

Beispiel 7:

Eine Mischung aus

60 Gwt. des in Beispiel 6 benutzten Epoxidacrylates

32,5 Gwt. des Urethanacrylates der Formel

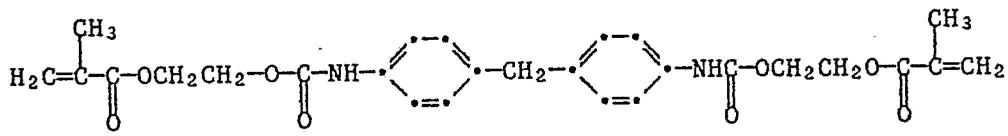

,

hergestellt durch Umsetzung von 4,4′-Diphenylmethandiisocyanat mit Hydroxyethylmethacrylat nach dem Verfahren von J. Kaiser et al., Israel J. Chem. 10, 157 (1972),

2,5 Gwt. Photoinitiator IV

5 Gwt. des in Beispiel 6 verwendeten Verlaufsmittelkonzentrates

0,5 Gwt. AEROSIL R972 (DEGUSSA)

0,2 Gwt. Kristallviolett

werden in einer Kugelmühle während 6 Stunden vermischt und fein vermahlen und dann durch ein Sieb von 100 µm Maschenweite gesiebt. Die Applikation und das Aufschmelzen erfolgt analog zum Beispiel 6. Man erhält einen gleichmässigen Film von ca. 60 µm Filmdicke. Nach der Belichtung und Entwicklung analog zum Beispiel 6 erhält man ein Bild mit einer guten Auflösung.

**Patentansprüche**

1. Verfahren zur Herstellung von photostrukturierbaren Ueberzügen worin
   (i) ein zu beschichtendes Material, gegebenenfalls nach Erwärmung, mit einem Pulverlack enthaltend
   (A) eine strahlungshärtbare Verbindung und gegebenenfalls
   (B) einen strahlungsaktivierbaren Polymerisationsinitiator für (A)
   elektrostatisch beschichtet wird,
   (ii) das beschichtete Material erwärmt wird, um ein Schmelzen des Pulvers zu einem Film, der nach Abkühlung fest ist, zu bewirken,
   (iii) der feste Film in einem vorbestimmten Muster aktinischer Strahlung ausgesetzt wird, bei der die strahlungshärtbare Verbindung (A) und/oder der strahlungsaktivierbare Polymerisationsinitiator (B) aktiviert werden, so dass in den bestrahlten Bereichen die Komponente (A) ganz oder teilweise gehärtet wird, gegebenenfalls
   (iv) das beschichtete Material erhitzt wird, und dadurch die belichteten Teile einer thermischen Nachbehandlung unterzogen werden,
   (v) die Bereiche des Films, die nicht gehärtet sind, durch Entwicklung entfernt werden und gegebenenfalls
   (vi) das beschichtete Material wieder erhitzt wird und dabei (A) nachgehärtet wird.
2. Verfahren nach Anspruch 1, worin der photostrukturierbare Ueberzug ein Galvanoresist oder vorzugsweise eine Lötstoppmaske ist.
3. Verfahren nach Anspruch 1, worin die strahlungshärtbare Verbindung (A) ein Epoxidharz mit durchschnittlich mehr als einer Epoxidgruppe pro Molekül ist, und vorzugsweise ein Polyglycidylderivat eines Aromaten, eines Heteroaromaten oder Cycloaliphaten ist.
4. Verfahren nach Anspruch 3, worin das Epoxidharz ein gegebenenfalls vorverlängerter Polyglycidylether eines Bisphenols oder vorzugsweise ein Polyglycidylether eines Novolaks ist.
5. Verfahren nach Anspruch 1, worin die strahlungshärtbare Verbindung (A) eine ethylenisch ungesättigte Verbindung ist.
6. Verfahren nach Anspruch 5, worin die Verbindung (A) ein Ester einer ethylenisch ungesättigten Monocarbonsäure, eine Vinylgruppen enthaltende Verbindung oder eine Maleinimideinheiten enthaltende Verbindung ist.
7. Verfahren nach Anspruch 6, worin die Verbindung (A) mindestens eine Gruppe der Formel II

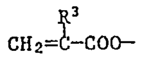

(II)

enthält, worin $R^3$ Wasserstoff, Chlor oder Brom oder eine $C_1$-$C_4$-Alkylgruppe ist.

8. Verfahren nach Anspruch 7, worin die Verbindung (A) ein Polyether-Acrylat, ein Polyester-Acrylat,

ein Polyester-Urethan-Acrylat, ein Urethanacrylat oder insbesondere ein Epoxid-Acrylat ist.

9. Verfahren nach Anspruch 1, worin der strahlungsaktivierbare Polymerisationsinitiator (B) ein kationischer Photoinitiator ist.

10. Verfahren nach Anspruch 9, worin der kationische Photoinitiator (B) ein Haloniumsalz, ein Iodosylsalz, ein Sulfoniumsalz, ein Sulfoxoniumsalz oder insbesondere ein Metallocensalz ist.

11. Verfahren nach Anspruch 10, worin der kationische Photoinitiator (B) ein Eisen-Aren-Komplex ist.

12. Verfahren nach Anspruch 1, worin der strahlungsaktivierbare Polymerisationsinitiator (B) ein radikalischer Photoinitiator ist.

13. Verfahren nach Anspruch 12, worin der radikalische Photoiniator (B) ein Benzoin, ein Benzophenon, ein Acetophenon, ein Thioxanthon oder ein Metallocen, insbesondere ein Titanocen, ist.

14. Verfahren nach Anspruch 1, worin der Pulverlack zusätzlich zu den Komponenten (A) und (B) noch Entgasungmittel, Verlaufsmittel, thermische Härter, Füllstoffe und/oder Pigmente enthält.

15. Verfahren nach Anspruch 1, worin der Pulverlack einen Erweichungspunkt im Bereich von etwa 50 bis 150° C, vorzugsweise etwa 65 bis 110° C hat.

16. Verfahren nach Anspruch 1, worin die aktinische Strahlung eine Wellenlänge im Bereich von etwa 300 bis 550 μm hat.